# EUROPÄISCHE PATENTSCHRIFT

(11) **EP 2 795 353 B1**
(45) Veröffentlichungstag und Bekanntmachung des Hinweises auf die Patenterteilung: **12.08.2015**
(21) Anmeldenummer: 12812824.6
(22) Anmeldetag: 06.12.2012
(51) Int. Cl.: G01R 31/40

(54) **VERFAHREN UND VORRICHTUNG ZUR INDUSTRIELLEN VERDRAHTUNG UND ENDPRÜFUNG VON PHOTOVOLTAISCHEN KONZENTRATORMODULEN**
METHOD AND DEVICE FOR THE INDUSTRIAL WIRING AND FINAL TESTING OF PHOTOVOLTAIC CONCENTRATOR MODULES
PROCÉDÉ ET DISPOSITIF POUR LE CÂBLAGE INDUSTRIEL ET LE CONTRÔLE FINAL DE MODULES CONCENTRATEURS PHOTOVOLTAÏQUES

(30) Priorität: 23.12.2011 DE 202011109424 U
(43) Veröffentlichungstag der Anmeldung: 29.10.2014
(73) Patentinhaber: Grenzebach Maschinenbau GmbH, 86663 Asbach-Baeumenheim (DE); Soitec Solar GmbH, 79111 Freiburg (DE)
(72) Erfinder: SCHMID, Markus, 86666 Burgheim (DE); FEINEIS, Alexander, 86609 Donauwörth (DE)
(74) Vertreter: Kindermann, Peter
(86) Internationale Anmeldenummer: PCT/DE2012/001159
(87) Internationale Veröffentlichungsnummer: WO 2013/091599

(56) Entgegenhaltungen:
- US-A1- 2005 217 718
- US-A1- 2011 107 887

## Beschreibung

Bereits seit vielen Jahren gibt es in der Photovoltaik Ansätze, mit konzentrierter Solarstrahlung zu arbeiten. Hierbei wird die Strahlung der Sonne mittels Spiegeln und / oder Linsen konzentriert, und auf spezielle Konzentrator - Solarzellen gerichtet. Entsprechende Systeme konzentrierender Photovoltaik (Concentrating Photovoltaics, CPV) werden derzeit im spanischen Solarforschungsinstitut Instituto de Sistemas Fotovoltaicos de Concentracion (ISFOC) in Kastilien bei Puertollano getestet. Sie bündeln das Sonnenlicht mit Linsen oder Spiegeln auf die vierhundert- bis tausendfache Intensität, bevor es auf kleine Solarzellen trifft, die deutlich effizienter sind als klassische Silizium - Solarzellen.

Hierzu wird aus der Patentliteratur folgender Stand der Technik genannt. Die Dokumente US 2005/217718 A und US 2011/107887 A beschreiben photo konzentratormodule.

In der US 4 834 805 A wird ein photovoltaisches Kraft - Modul offenbart, im Wesentlichen mit den folgenden Merkmalen.

Einer Anordnung von photovoltaischen Halbleiter - Kristallzellen, verteilt in individuellen Zell - Standorten in einem geschichteten Substrat, wobei diese von zwei elektrisch leitenden Schichten eingeschlossen und mittels einer Isolierschicht getrennt sind. Ferner besteht dieses Modul aus einer lichtfördernden Schicht aus Linsen die in einer Entfernung zu dem geschichteten Substrat angeordnet ist, wobei einfallende Strahlung in der lichtfördernden Schicht mittels der Linsen in das Substrat fokussiert wird, und wobei die gesamte Dicke der Linsenschicht, der Substratschicht und des Raums dazwischen ca.2 inch beträgt.

Aus der DE 10 2006 007 472 A1 ist ein photovoltaisches Konzentratormodul mit einer Linsenplatte und einer Bodenplatte, auf welcher Solarzellen untergebracht sind, und einem Rahmen bekannt, wobei der Rahmen die Linsenplatte und die Bodenplatte verbindend, längs des Randes der Linsenplatte und der Bodenplatte umlaufend angeordnet ist.

Diese bekannte Konzentratormodul soll dahingehend verbessert werden, dass es kostengünstig hergestellt werden kann, langlebig ist, und es erlaubt, einfach und flexibel zusätzliche Komponenten zu integrieren die auf der Linsenplatte oder der Bodenplatte nicht oder nur schwierig untergebracht werden können. Darüber hinaus soll ein Verfahren entwickelt werden, das die Herstellung solcher Konzentratormodule ermöglicht.

Die hier gestellte Aufgabe wird dadurch gelöst, dass entlang des Rahmens zwischen der Linsenplatte und dem Rahmen und / oder der Bodenplatte und dem Rahmen zum einen mindestens eine erste Dichtmasse und / oder Klebemasse und zum anderen mindestens eine zweite Dichtmasse zumindest auf einem Teil der Länge des Rahmens umlaufend angeordnet ist, wobei die beiden Dicht - und / oder Klebemassen sich bezüglich ihrer Aushärtezeit und / oder Gasdurchlässigkeit unterscheiden.

Im Anspruch 57 wird ein Verfahren zur Herstellung eines photovoltaischen Konzentratormoduls nach einem der vorhergehenden Ansprüche beansprucht, das durch die folgenden Merkmale gekennzeichnet ist.

Nämlich dass ein Rahmen, eine Linsenplatte und eine Bodenplatte verbindend, längs dem Rand der Linsenplatte und der Bodenplatte angeordnet wird, und dass zwischen den Rahmen und die Linsenplatte und / oder den Rahmen und die Bodenplatte zu einen mindestens eine erste Dichtmasse und / oder Klebemasse und zum anderen mindestens eine zweite Dichtmasse entlang des Rahmens über zumindest einen Teil seiner Länge umlaufend , eingebracht wird, wobei die beiden Dicht - und / oder Klebemassen sich bezüglich ihrer Aushärtezeiten und / oder Gasdurchlässigkeiten unterscheiden.

Dass eine der Klebemassen zur Fixierung einer Platte während des Herstellungsprozesses mittels UV - Licht dient, ist hier nicht zu entnehmen.

Die DE 10 2010 016 675 A1 beschreibt ein Photovoltaikmodul, ein Verfahren zum elektrischen Verbinden einer Mehrzahl von Photovoltaikzellen und eine Einrichtung zum elektrischen Verbinden einer Mehrzahl von Photovoltaikzeilen.

Gemäß Anspruch 11 wird hier ein Verfahren zum elektrischen Verbinden einer Mehrzahl von Photovoltaikzellen beansprucht, wobei das Verfahren folgende Merkmale aufweist:
1) Aufbringen einer ersten Mehrzahl von Kontaktdrähten auf einer Vorderseite einer ersten Photovoltaikzelle,
2) Aufbringen einer zweiten Mehrzahl von Kontaktdrähten auf einer Rückseite der ersten Photovoltaikzelle,
3) Aufbringen der ersten Mehrzahl von Kontaktdrähten auf einer Rückseite einer zweiten Photovoltaikzelle , und
4) Aufbringen der zweiten Mehrzahl von Kontaktdrähten auf einer Vorderseite der zweiten Photovoltaikzelle, wobei
5) die erste Mehrzahl von Kontaktdrähten und die zweite Mehrzahl von Kontaktdrähten zueinander versetzt angeordnet werden.

Als aufgabenähnliche Angabe ist dieser Druckschrift zu entnehmen, dass ein verbessertes Photovoltaikmodul kreiert werden soll, also die Kontaktstruktur der Photovoltaikzelle und die Anzahl und Dimension der Kontaktbändchen ( Kontaktdrähte) kombiniert optimiert werden

Der erfindungsgemäßen Vorrichtung bzw. dem entsprechenden Verfahren liegt die Aufgabe zugrunde, eine Vorrichtung und ein Verfahren vorzustellen mit dem industriell hergestellte Konzentratormodule industriell preiswert und zuverlässig verdrahtet werden können und eine zuverlässige Endprüfung durchgeführt werden kann, sodass im praktischen Betrieb eine hohe Langzeitstabilität eines Konzentratormoduls erreicht wird

Diese Aufgabe wird mit einer Vorrichtung nach
Anspruch 1
   Vorrichtung zur industriellen Verdrahtung und Endprüfung von photovoltaischen Konzentratormodulen, bestehend aus einem Modulrahmen, einer Linsenscheibe, einer Sensorträgerscheibe und einer elektrischen Leitungsführung, mit den folgenden Merkmalen:
   a) einer Laser - Kontaktiereinrichtung zum berührungslosen Verbinden von Verbindungsleitungen zwischen den einzelnen Sensoren ( 11 ) und von Verbindungselementen ( 17 ) und von Sammelkontaktplatten ( 19 ), wobei die Leitungsführung auf der Sensorträgerscheibe ( 13 ) als Grundstruktur jeweils 5 CPV-Sensoren in Parallelschaltung aufweist, und diese Parallelschaltungen in Serie geschaltet sind, und wobei die, auf die Sensorträgerscheibe ( 13 ) aufzubringenden, elektrischen Verbindungsleitungen, Verbindungselemente ( 17 ) und Sammelkontaktplatten ( 19 ) automatisch einem Vorratslager entnommen und in den Bereich entsprechender Haltemittel verbracht werden, und wobei die Kontaktierungs - Partner vor dem Verbinden mittels einer Laser - Kontaktierungseinrichtung von automatisch gesteuerten Haltemitteln in ihrer Sollstellung fixiert werden, und wobei die Laser - Kontaktiereinrichtung sicher stellt, dass die beiden zu verbindenden Leiter von dem Verbindungswerkzeug nicht berührt werden, nur sehr kurzzeitig erhitzt werden und sich deshalb nahezu nicht verformen, und wobei sich die Positionierung der Haltemittel lasergesteuert an Markierungen am Konzentratormodul orientiert,
   b) einer Einrichtung, zur Prüfung elektrischer Eigenschaften, wobei CPV - Sensoren ( 11 ) selbst mit einer bestimmten Spannung beaufschlagt werden, und das von ihnen über die Linsen (15 ) ausgesandte Licht erfasst und bewertet wird, wobei erkannte Fertigungsfehler ausgebessert werden,
   c) einer Einrichtung zur Dichtheitsprüfung ( 5 ) fertiger Konzentratormodule, wobei diese im Inneren mit Druckluft beaufschlagt werden und die Emission der Druckluft überprüft wird
   bzw.einem Verfahren nach
Anspruch 2:
   Verfahren zur industriellen Verdrahtung und Endprüfung von photovoltaischen Konzentratormodulen, bestehend aus einem Modulrahmen, einer Linsenscheibe, einer Sensorträgerscheibe und einer elektrischen Leitungsführung, mit den folgenden Merkmalen:
   a) das Konzentratormodul wird nach dem Aufbringen der Sensorträgerscheibe ( 13 ) in den Fertigungsbereich der elektrischen Kontaktierung verbracht,
   b) es werden die benötigten Verbindungsleitungen, Verbindungselemente ( 17 ) und Sammelkontaktplatten ( 19 ) jeweils einem Vorratslager entnommen, von automatisch gesteuerten Haltemitteln positioniert und mittels einer automatisch gesteuerten Laser - Kontaktiereinrichtung elektrisch leitend verbunden,
   c) die Sammelkontaktplatten ( 19 ) der kontaktierten Teilschaltungen werden schaltungstechnisch verbunden und die hieraus resultierenden Sammel - Leitungen ( 8, 9 ) werden einem externen Anschlusselement zugeführt, wobei in der Folge das Konzentratormodul mit einer Linsenscheibe ( 16 ) versehen wird,
   d) anschließend wird das Konzentratormodul einer Einrichtung zur Prüfung elektrischer Eigenschaften zugeführt, wobei CPV-Sensoren ( 11 ) selbst mit einer bestimmten Spannung beaufschlagt werden, und das von ihnen über die Linsen (15 ) ausgesandte Licht erfasst und bewertet wird,
   e) danach wird das Konzentratormodul einer Einrichtung zur Dichtheitsprüfung ( 5 ) fertiger Konzentratormodule verbracht, wobei diese im Inneren mit Druckluft beaufschlagt werden und die Emission der Druckluft überprüft wird,
   f) die Ergebnisse der Messung des erzeugten Lichtstroms und der Dichteprüfung werden zur Bewertung der Qualität des betreffenden Konzentratormoduls verwandt und es wird eine entsprechende Einordnung vorgenommen.
Anspruch 3.
   Verfahren nach Anspruch 2,
   dadurch gekennzeichnet,
   dass die, auf die Sensorträgerscheibe ( 13 ) aufzubringenden, elektrischen Verbindungsleitungen, Verbindungselemente ( 17 ) und Sammelkontaktplatten ( 19 ) automatisch einem Vorratslager entnommen und in den Bereich entsprechender Haltemittel verbracht werden.
Anspruch 4 .
   Verfahren nach Anspruch 2 oder 3,
   dadurch gekennzeichnet,
   dass die Kontaktierungs - Partner vor dem Verbinden mittels der Laser - Kontaktierungseinrichtung von automatisch gesteuerten Haltemitteln in ihrer Sollstellung fixiert werden, und wobei die Laser-Kontaktierungseinrichtung sicher stellt, dass die beiden zu verbindenden Leiter von dem Verbindungswerkzeug nicht berührt werden, nur sehr kurzzeitig erhitzt werden und sich deshalb nahezu nicht verformen.
Anspruch 5:
   Verfahren nach einem der Ansprüche 2 bis 4,
   dadurch gekennzeichnet,
   dass die Positionierung der Haltemittel lasergesteuert sich an
   Markierungen am Konzentratormo
gelöst.

Die erfindungsgemäße Vorrichtung wird im Folgenden näher beschrieben. Es zeigen dabei im Einzelnen:
- Fig. 1:: eine Anlage zur Fertigung von Konzentratormodulen in der Draufsicht,
- Fig. 2:: einen Querschnitt durch ein Konzentratormodul,
- Fig. 3:: eine Teilfläche einer Sensorträgerscheibe,
- Fig. 4:: eine Gesamtfläche einer Sensorträgerscheibe eines Konzentratormoduls,
- Fig. 5:: eine Ansicht eines Teilaspekts der Fig. 4
- Fig. 6:: einen Querschnitt durch die verwendete Laser - Kontaktiereinrichtung

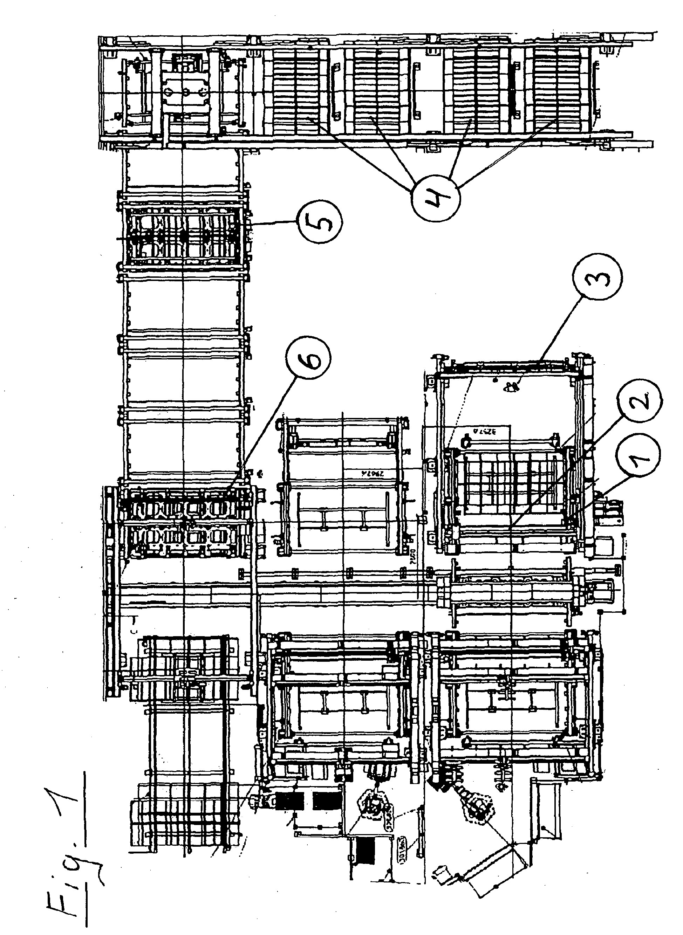

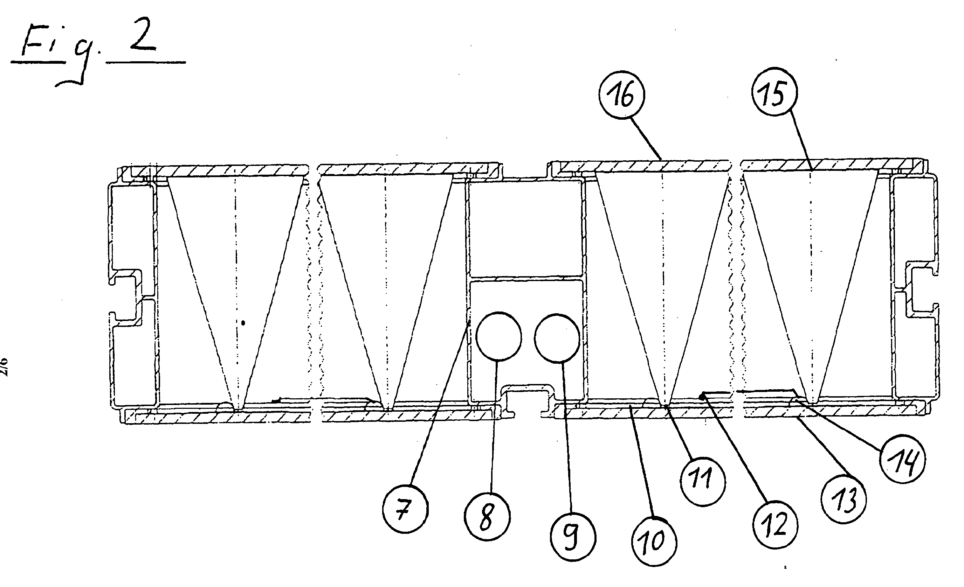

In der Fig. 1 ist eine Anlage zur Fertigung von Konzentratormodulen in der Draufsicht dargestellt, wie sie in der Fig. 2 im Querschnitt gezeigt sind.

Hier wird jedoch nur der mit Bezugszeichen versehene Teil der gesamten Fertigungsanlage betrachtet. Der Fertigungsprozess bis zum Zeitpunkt der Verdrahtung eines Konzentratormoduls ist nicht Teil der Erfindung.

Zum Zeitpunkt der Verdrahtung eines solchen Moduls ist die Sensorträgerscheibe 13 schon mit dem Rahmen des Moduls verbunden und erfährt im nächsten Bearbeitungsschritt nach der Verdrahtung die Verbindung mit der, der Sensorträgerscheibe 13 parallel gegenüber liegenden, Linsenscheibe 16. An dem in der Fig. 1 eingezeichneten Kontaktierplatz 3 befindet sich ein Laserportal 2 das einen Laserkopf 1 trägt. Mittels dieses Portals 2 kann ein Modulrahmen an jeder zu kontaktierenden Stelle von dem Laserkopf 1 erreicht werden.

Der Prüfplatz 5 für die Dichteprüfung und der Prüfplatz 6 für die abschließende elektrische Prüfung werden später beschrieben.

Die Stapelplätze 4 ermöglichen die Einordnung nach Qualitätsstufen, die im Wesentlichen von den Ergebnissen auf dem Prüfplatz 5 für die Dichteprüfung und dem Prüfplatz 6 für die abschließende elektrische Prüfung bestimmt werden.

Die Fig. 2 zeigt einen Querschnitt durch ein Konzentratormodul.

Dieser lässt ein Konzentratormodul mit seinem tragenden Modulrahmen im Querschnitt in vergrößerter Darstellung erkennen. Auf der Oberseite sind hier jeweils eine Linsenscheibe 16 mit einer Linse 15 und an der Unterseite eine Sensorträgerscheibe 13 zu erkennen. Der Modulrahmen ist hierbei auf jeder Seite in seiner Querausdehnung unterbrochen dargestellt, um die gezeigten Einzelheiten in den wahren Größenverhältnissen zeigen zu können. In der Linsenscheibe 16 finden sich auf der rechten Seite Hinweise auf die verwendeten Fresnel - Linsen 15, und in der Sensorträgerscheibe 13 die entsprechenden Kontaktpunkte 14 der CPV-Sensoren 11 und die zugehörigen Kontaktpunkte 12 mit der Kühl - und Kontaktplatte 10. Zudem ist in diesem Bereich eine Verbindungsleitung zwischen einem Kontaktpunkt 14 des rechts dargestellten CPV - Sensors und einem, durch die doppelte Risslinie getrennten, Kontaktpunkt 12 auf der Kühl - und Kontaktplatte 10 eines anderen, links von dem ersten CPV - Sensor liegenden, anderen CPV - Sensors 11 zu erkennen. Selbstverständlich sind diese beiden CPV - Sensoren in der Praxis nicht direkt miteinander verbunden, da sie durch die doppelte Risslinie getrennt sind. Im Bereich des Mittelstegs 7 des gezeigten Konzentratormoduls sind die Sammel - Leitung 8 mit negativer Polarität und die Sammel - Leitung 9 mit positiver Polarität dargestellt.

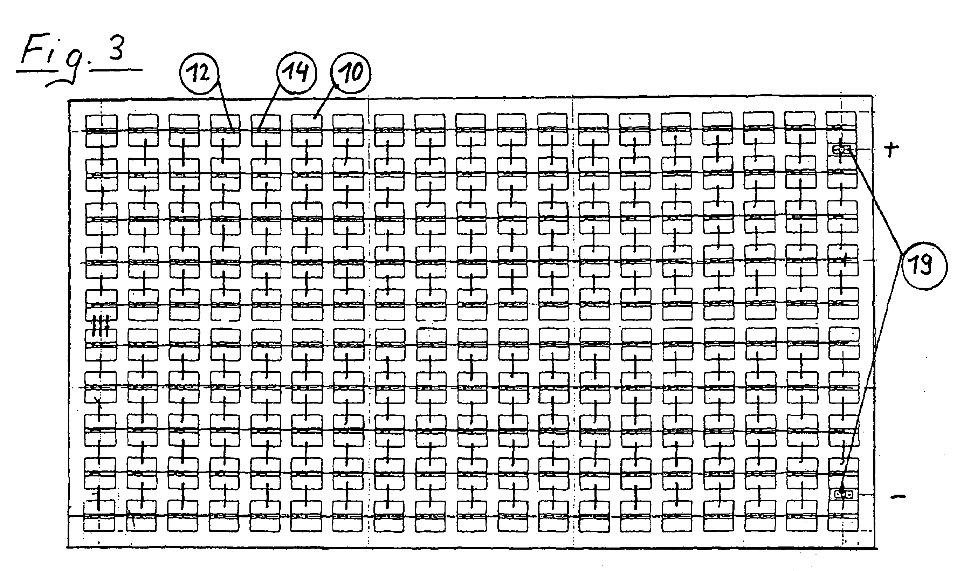

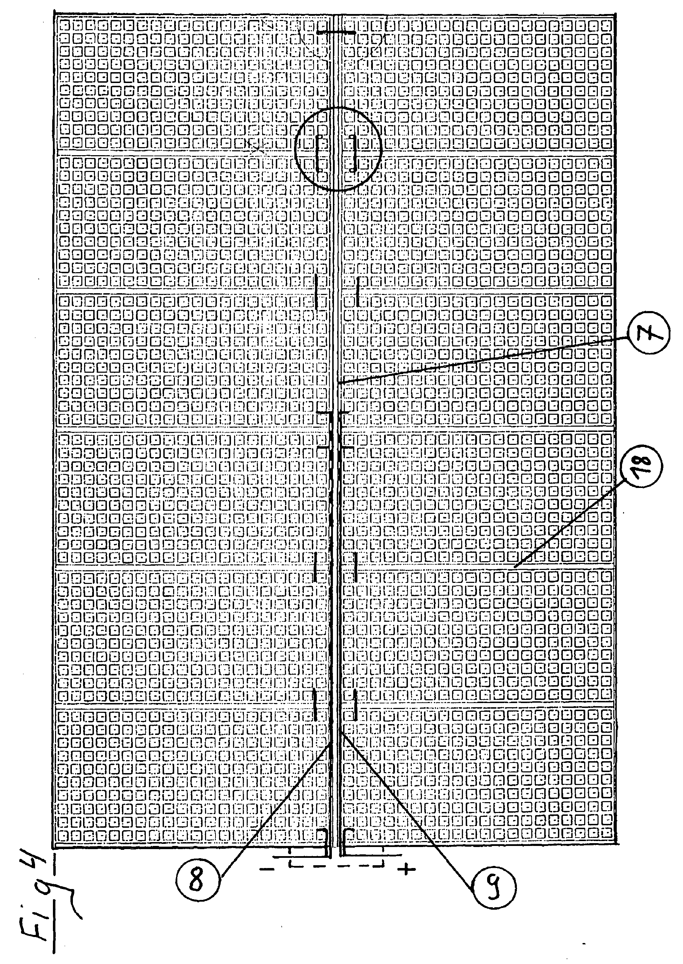

Die Fig. 3 zeigt eine der 12 Teilflächen einer Sensorträgerscheibe 13, wie sie insgesamt in der Fig. 4 zu sehen ist.

In der obersten Reihe der zahlenmäßig 19 dargestellten CPV - Sensoren 11 sind beispielhaft eine Kühl - und Kontaktplatte 10, ein Kontaktpunkt 12 auf einer solchen Kontaktplatte 10 und ein Kontaktpunkt 14 eines CPV - Sensors auf einer Sensorträgerscheibe 13 von oben gesehen gesondert bezeichnet. Auf der rechten Seite der Sensorträgerscheibe 13 sind oben eine Sammelkontaktplatte 19 mit positiver Polarität und unten eine Sammelkontaktplatte mit negativer Polarität zu erkennen. Zur Stromgewinnung sind als Grundstruktur jeweils 5 CPV - Sensoren parallel geschaltet und diese Parallelschaltungen sind wiederum in Serie geschaltet, sodass sich die Spannungen der Parallelschaltungen aufaddieren. In der, in der Fig. 3 gezeigten, Darstellung sind auf diese Weise 19 Parallelschaltung von jeweils 5 CPV - Sensoren in Serie geschaltet, wobei diese sich über die Längsseite dieser Teilfläche erstrecken. Da sich auf der gezeigten Teilfläche jedoch auf der Breitseite weitere 5 CPV - Sensoren befinden mit derselben Anzahl von Parallelschaltungen, addieren sich auch hier deren Spannungen auf. Als Summenspannung des in der Figur 3 gezeigten Teilfläche ergibt sich somit die Summe von 2 mal 19 jeweils parallel geschalteten Anordnungen von jeweils 5 CPV - Sensoren. Auf diese Weise lassen sich durch die Zusammenschaltung von 2 mal 6 Teilflächen Gesamtspannungen von bis zu 1000 Volt erzeugen.

Die Fig.4 zeigt eine Sensorträgerscheibe 13 eines Konzentratormoduls.

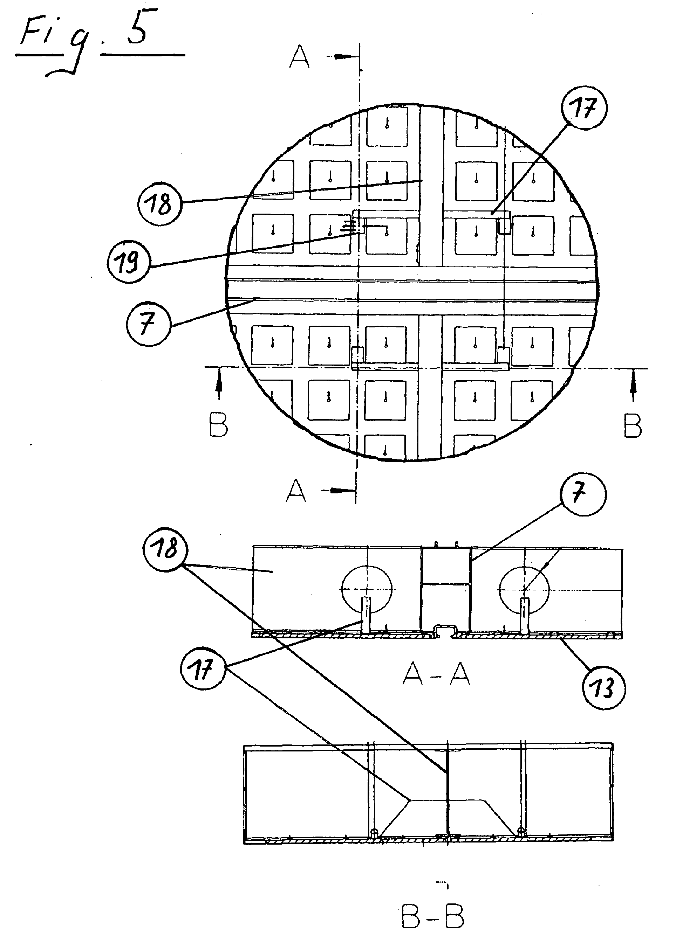

In der Mitte der Sensorträgerscheibe 13 ist über die ganze Länge der Mittelsteg 7 des gezeigten Konzentratormoduls, der in der Fig. 2 im Querschnitt dargestellt ist, von oben zu erkennen. Desgleichen ist der 2. Quersteg von links von insgesamt 5 Stück des Konzentratormoduls mit 18 bezeichnet. Die Sammel - Leitung 8 mit negativer Polarität und die entsprechende Sammel - Leitung 9 mit positiver Polarität, wie auch der Fig. 2 im Querschnitt zu entnehmen ist, führen den von dem Konzentratormodul insgesamt gelieferten Strom im Wesentlichen aus der geometrischen Mitte der Sensorträgerscheibe an den Rand in den Bereich eines Anschluss - Elements. Dieses Element ist nicht extra dargestellt. Am rechten Rand der Querseite der gezeigten Sensorträgerscheibe 13 ist eine weitere Sammelkontaktplatte mit 19 bezeichnet. Der, die 4 Eckpunkte der 4 rechts gelegenen Teilflächen der Sensorträgerscheibe 13 umschließende, Kreis findet sich in der Vergrößerung der Fig. 5 wieder.

Die Fig. 5 zeigt den aus der Fig. 4 bekannten Kennzeichnungs - Kreis als eine Ansicht eines Teilaspekts der Fig. 4. Dieser Kennzeichnungs - Kreis lässt in der Mitte den quer verlaufenden Mittelsteg 7 des Konzentratormoduls aus der Fig. 4 erkennen. Senkrecht zu dem Mittelsteg 7 verläuftein, von oben ebenfalls sichtbarer, Querträger 18. Oberhalb und unterhalb des Mittelstegs 7 verläuft, parallel zu diesem, jeweils ein Verbindungselement 17, das jeweils von einer Sammelkontaktplatte 19 zu einer anderen Sammelkontaktplatte 19 einer Teilfläche nach der Fig. 3 führt. Diese Sammelkontaktplatten 19 führen jeweils den gesamten Strom einer der gezeigten 12 Teilflächen der Sensorträgerscheibe und sind deshalb hinsichtlich ihrer Belastbarkeit entsprechend ausgelegt. Die in der Fig. 4 insgesamt eingezeichneten Verbindungselemente 17 gewährleisten die elektrische Serienschaltung aller 12 Teilflächen

In der unteren Bildhälfte der Fig. 5 ist im Schnitt A - A ein Querschnitt quer zum Mittelsteg 7 an einer Stelle mit Blick auf den, im Kennzeichnungs - Kreis dargestellten, Querträger 18 dargestellt. Hier sind, neben der Sensorträgerscheibe13 und dem Mittelsteg 7 in dem Querträger 18 jeweils links und rechts von dem Mittelsteg 7 eine kreisförmige Öffnung gezeigt, durch die jeweils ein Verbindungselement 17 führt.

In dem darunter gezeigten Querschnitt B - B ist entsprechend ein Verbindungselement 17 mit seinem brückenförmigen Verlauf, um 90 Grad gedreht, im Querschnitt zu erkennen.

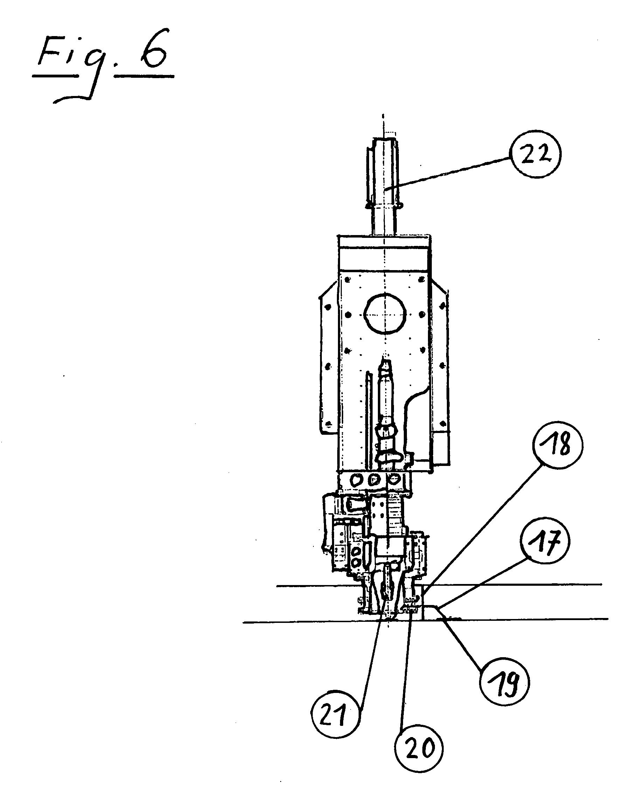

Fig. 6 zeigt einen Querschnitt durch die verwendete Laser - Kontaktiereinrichtung.

Diese Laser - Kontaktiereinrichtung gewährleistet eine berührungslose, schnelle und sichere Kontaktierung als elektrische Verbindung zweier elektrischer Leiter. Die Verwendung eines Lasers in diesem Bereich stellt sicher, dass die beiden zu verbindenden Leiter von dem Verbindungswerkzeug nicht berührt werden, nur sehr kurzzeitig erhitzt werden, dass sie sich deshalb nahezu nicht verformen und deshalb mittels automatischer Justiermittel verarbeitet werden können. Die Laser - Kontaktiereinrichtung wird mittels eines Aufnahmeschafts 22 für einen Portalträgerkopf geführt und gesteuert. Am gezeigten Beispiel wird ein Verbindungselement mit jeweils einer Sammelkontaktplatte 19, mittels eines Greifers 20 und dem Laser 21 elektrisch leitend verbunden.

Zur Halterung der durch die Laser - Kontaktiereinrichtung zu verbindenden Kontaktierungselemente, bzw. Kontaktierungspartner, sind entsprechende Haltemittel vorgesehen, die lasergesteuert sich an speziellen Markierungen des Konzentratormoduls orientieren. Ihre Verwendung ist nicht gesondert dargestellt.

Nach der Kontaktierung aller notwendigen elektrischen Verbindungen und dem Aufbringen einer Linsenscheibe 16 werden die soweit verfertigten Konzentratormodule einer Einrichtung zur Prüfung elektrischer Eigenschaften zugeführt, wobei CPV - Sensoren ( 11 ) selbst mit einer bestimmten Spannung beaufschlagt werden, und das von ihnen über die Linsen (15 ) ausgesandte Licht erfasst und bewertet wird. Werden in diesem Bereich Fertigungsfehler entdeckt, kann eine Ausbesserung von Hand oder automatisch erfolgen.

Nach der endgültigen Fertigstellung eines Konzentratormoduls werden die Konzentratormodule einer Einrichtung zur Dichtheitsprüfung ( 5 ) zugeführt, wobei diese im Inneren mit Druckluft beaufschlagt werden und die Emission der Druckluft überprüft wird.

Die Steuerung der komplexen Bewegungsvorgänge und die Signalverarbeitung der verwendeten Sensoren erfordern eine spezielle Regelung.

### Bezugszeichenliste

- 1: Laserkopf
- 2: Laserportal
- 3: Kontaktierplatz
- 4: Stapelplätze
- 5: Prüfplatz ( Dichteprüfung )
- 6: Prüfplatz ( Elektrik )
- 7: Mittelsteg eines Konzentratormoduls
- 8: Sammel - Leitung ( Minuspol )
- 9: Sammel - Leitung ( Pluspol )
- 10: Kühl - und Kontaktplatte
- 11: CPV - Sensor ( Absorber )
- 12: Kontaktpunkt auf der Platte 10
- 13: Sensorträgerscheibe eines Konzentratormoduls
- 14: Kontaktpunkt eines CPV - Sensors ( Absorbers )
- 15: Linse
- 16: Linsenscheibe
- 17: Verbindungselement ( Flachband oder Kabel )
- 18: Querträger
- 19: Sammelkontaktplatte
- 20: Greifer
- 21: Laser
- 22: Aufnahmeschaft für Portalträgerkopf

## Patentansprüche

1. Vorrichtung zur industriellen Verdrahtung und Endprüfung von photovoltaischen Konzentratormodulen, bestehend aus einem Modulrahmen, einer Linsenscheibe, einer Sensorträgerscheibe und einer elektrischen Leitungsführung, mit den folgenden Merkmalen:
a) einer Laser - Kontaktiereinrichtung zum berührungslosen Verbinden von Verbindungsleitungen zwischen den einzelnen Sensoren ( 11 ) und von Verbindungselementen ( 17 ) und von Sammelkontaktplatten ( 19 ), wobei die Leitungsführung auf der Sensorträgerscheibe ( 13 ) als Grundstruktur jeweils 5 CPV - Sensoren in Parallelschaltung aufweiset, und diese Parallelschaltungen in Serie geschaltet sind, und wobei die, auf die Sensorträgerscheibe ( 13 ) aufzubringenden, elektrischen Verbindungsleitungen, Verbindungselemente ( 17 ) und Sammelkontaktplatten ( 19 ) automatisch einem Vorratslager entnommen und in den Bereich entsprechender Haltemittel verbracht werden, und wobei die Kontaktierungs - Partner vor dem Verbinden mittels einer Laser - Kontaktierungseinrichtung von automatisch gesteuerten Haltemitteln in ihrer Sollstellung fixiert werden, und wobei die Laser - Kontaktiereinrichtung sicher stellt, dass die beiden zu verbindenden Leiter von dem Verbindungswerkzeug nicht berührt werden, nur sehr kurzzeitig erhitzt werden und sich deshalb nahezu nicht verformen, und wobei sich die Positionierung der Haltemittel lasergesteuert an Markierungen am Konzentratormodul orientiert,
b) einer Einrichtung, zur Prüfung elektrischer Eigenschaften, wobei CPV - Sensoren ( 11 ) selbst mit einer bestimmten Spannung beaufschlagt werden, und das von ihnen über die Linsen (15 ) ausgesandte Licht erfasst und bewertet wird, wobei erkannte Fertigungsfehler ausgebessert werden,
c) einer Einrichtung zur Dichtheitsprüfung ( 5 ) fertiger Konzentratormodule, wobei diese im Inneren mit Druckluft beaufschlagt werden und die Emission der Druckluft überprüft wird

2. Verfahren zur industriellen Verdrahtung und Endprüfung von photovoltaischen Konzentratormodulen, bestehend aus einem Modulrahmen, einer Linsenscheibe, einer Sensorträgerscheibe und einer elektrischen Leitungsführung, mit den folgenden Merkmalen:
a) das Konzentratormodul wird nach dem Aufbringen der Sensorträgerscheibe ( 13 ) in den Fertigungsbereich der elektrischen Kontaktierung verbracht,
b) es werden die benötigten Verbindungsleitungen, Verbindungselemente ( 17 ) und Sammelkoritaktplatten ( 19 ) jeweils einem Vorratslager entnommen, von automatisch gesteuerten Haltemitteln positioniert und mittels einer automatisch gesteuerten Laser - Kontaktiereinrichtung elektrisch leitend verbunden,
c) die Sammelkontaktplatten ( 19 ) der kontaktierten Teilschaltungen werden schaltungstechnisch verbunden und die hieraus resultierenden Sammel - Leitungen ( 8, 9 ) werden einem externen Anschlusselement zugeführt, wobei in der Folge das Konzentratormodul mit einer Linsenscheibe ( 16 ) versehen wird,
d) anschließend wird das Konzentratormodul einer Einrichtung zur Prüfung elektrischer Eigenschaften zugeführt, wobei CPV - Sensoren ( 11 ) selbst mit einer bestimmten Spannung beaufschlagt werden, und das von ihnen über die Linsen (15 ) ausgesandte Licht erfasst und bewertet wird,
e) danach wird das Konzentratormodul einer Einrichtung zur Dichtheitsprüfung ( 5 ) fertiger Konzentratormodule verbracht, wobei diese im Inneren mit Druckluft beaufschlagt werden und die Emission der Druckluft überprüft wird,
f) die Ergebnisse der Messung des erzeugten Lichtstroms und der Dichteprüfung werden zur Bewertung der Qualität des betreffenden Konzentratormoduls verwandt und es wird eine entsprechende Einordnung vorgenommen.

3. Verfahren nach Anspruch 2,
**dadurch gekennzeichnet,**
**dass** die, auf die Sensorträgerscheibe ( 13 ) aufzubringenden, elektrischen Verbindungsleitungen, Verbindungselemente ( 17 ) und Sammelkontaktplatten ( 19 ) automatisch einem Vorratslager entnommen und in den Bereich entsprechender Haltemittel verbracht werden.

4. Verfahren nach Anspruch 2 oder 3,
**dadurch gekennzeichnet,**
**dass** die Kontaktierungs - Partner vor dem Verbinden mittels der Laser - Kontaktierungseinrichtung von automatisch gesteuerten Haltemitteln in ihrer Sollstellung fixiert werden, und wobei die Laser - Kontaktierungseinrichtung sicher stellt, dass die beiden zu verbindenden Leiter von dem Verbindungswerkzeug nicht berührt werden, nur sehr kurzzeitig erhitzt werden und sich deshalb nahezu nicht verformen.

5. Verfahren nach einem der Ansprüche 2 bis 4,
**dadurch gekennzeichnet,**
**dass** die Positionierung der Haltemittel lasergesteuert sich an Markierungen am Konzentratormodul orientiert.

## Claims

1. Device for the industrial wiring and final testing of photovoltaic concentrator modules consisting of a module frame, a lens pane, a sensor carrier pane, and an electric line guide, comprising the following features:
a) a laser contacting arrangement for contactlessly connecting connection lines between the individual sensors (11) and connection elements (17) and collector contact plates (19), wherein the line guide on the sensor carrier pane (13) has in each case 5 CPV sensors connected in parallel as the basic structure, and these parallel connections are connected in series, and wherein the electric connection lines, connection elements (17) and collector contact plates (19) to be applied to the sensor carrier pane (13) are removed automatically from a stored supply and are brought into the region of corresponding holding means, and wherein the contact partners, before the connection by means of a laser contacting arrangement, are fixed in their target position by automatically controlled holding means, and wherein the laser contacting arrangement ensures that the two conductors to be connected are not contacted by the connection tool, are heated only for a very short period of time, and therefore practically do not deform, and wherein the positioning of the holding means is oriented in a laser-controlled manner toward markings on the concentrator module,
b) an arrangement for testing electrical properties, wherein a certain voltage is applied to CPV sensors (11) themselves and the light emitted therefrom via the lenses (15) is detected and evaluated, wherein identified manufacturing faults are corrected,
c) an arrangement for testing the tightness (5) of finished concentrator modules, wherein compressed air is applied to the interior of these modules and testing for the emission of compressed air is performed.

2. Method for the industrial wiring and final testing of photovoltaic concentrator modules consisting of a module frame, a lens pane, a sensor carrier pane, and an electric line guide, comprising the following features:
a) once the sensor carrier pane (13) has been applied, the concentrator module is brought into the manufacturing region of the electric contacting,
b) the required connection lines, connection elements (17) and collector contact plates (19) are each removed from a stored supply, positioned by automatically controlled holding means, and electrically conductively connected by means of an automatically controlled laser contacting arrangement,
c) the collector contact plates (19) of the contacted sub-circuits are electrically connected and the resultant collector lines (8, 9) are fed to an external connection element, wherein the concentrator module is then provided with a lens pane (16),
d) the concentrator module is fed to an arrangement for testing electrical properties, wherein a certain voltage is applied to CPV sensors (11) themselves and the light emitted therefrom via the lenses (15) is detected and evaluated,
e) the concentrator module is then fed to an arrangement for testing the tightness (5) of finished concentrator modules, wherein compressed air is applied to the interior of these modules and testing for the emission of compressed air is performed,
f) the results of the measurement of the generated luminous flux and of the tightness test are used to assess the quality of the concentrator module in question, and a corresponding classification is performed.

3. Method according to Claim 2,
**characterized in that**
the electric connection lines, connection elements (17) and collector contact plates (19) to be applied to the sensor carrier pane (13) are automatically removed from a stored supply and are brought into the region of corresponding holding means.

4. Method according to Claim 2 or 3,
**characterized in that**
the contact partners, before the connection by means of the laser contacting arrangement, are fixed in their target position by automatically controlled holding means, and wherein the laser contacting arrangement ensures that the two conductors to be connected are not contacted by the connection tool, are heated only for a very short period of time, and therefore practically do not deform.

5. Method according to one of Claims 2 to 4,
**characterized in that**
the positioning of the holding means is oriented in a laser-controlled manner toward markings on the concentrator module.

## Revendications

1. Appareil pour le câblage industriel et le contrôle final de modules concentrateurs photovoltaïques, composés d'un châssis de module, d'une plaque de lentille, d'une plaque porte-capteur et d'un tracé de ligne électrique, possédant les caractéristiques suivantes :
a) un dispositif de mise en contact à laser destiné à la connexion sans contact de lignes de liaison entre les capteurs individuels (11) et d'éléments de liaison (17) et de plaques de contact collectrices (19), le tracé de ligne présentant en tant que structure de base sur la plaque porte-capteur (13) à chaque fois 5 capteurs CPV branchés en parallèle, et ces circuits parallèles étant branchés en série, et les lignes de liaison électriques, éléments de liaison (17) et plaques de contact collectrices (19) à apposer sur la plaque porte-capteur (13) étant prélevés automatiquement d'un stock et amenés dans la zone de moyens de maintien correspondants, et les partenaires de mise en contact étant fixés dans leur position voulue par des moyens de maintien commandés automatiquement avant la connexion au moyen d'un dispositif de mise en contact à laser, et le dispositif de mise en contact à laser garantissant que les deux conducteurs à relier ne sont pas touchés par l'outil de connexion, ne sont chauffés que pendant un temps très court et par conséquent ne se déforment quasiment pas, et le positionnement des moyens de maintien étant orienté par commande laser sur des repères sur le module concentrateur,
b) un dispositif destiné à contrôler des caractéristiques électriques, les capteurs CPV (11) eux-mêmes étant alimentés avec une tension donnée, et la lumière émise par eux par le biais des lentilles (15) étant captée et évaluée, les erreurs de fabrication identifiées étant corrigées,
c) un dispositif destiné à contrôler l'étanchéité (5) des modules concentrateurs finis, ceux-ci étant chargés à l'intérieur avec de l'air comprimé et l'émission d'air comprimé étant contrôlée.

2. Procédé pour le câblage industriel et le contrôle final de modules concentrateurs photovoltaïques, composés d'un châssis de module, d'une plaque de lentille, d'une plaque porte-capteur et d'un tracé de ligne électrique, possédant les caractéristiques suivantes :
a) après avoir posé la plaque porte-capteur (13), le module concentrateur est amené dans la zone de fabrication de la mise en contact électrique,
b) les lignes de liaison, éléments de liaison (17) et plaques de contact collectrices (19) nécessaires sont respectivement prélevés d'un stock, positionnés par des moyens de maintien commandés automatiquement et reliés de manière électriquement conductrice au moyen d'un dispositif de mise en contact à laser à commande automatique,
c) les plaques de contact collectrices (19) des circuits partiels mis en contact sont reliées par technique de commutation et les lignes collectrices (8, 9) qui en résultent sont acheminées à un élément de raccordement externe, le module concentrateur étant ensuite muni d'une plaque de lentille (16),
d) le module concentrateur est ensuite acheminé à un dispositif destiné à contrôler des caractéristiques électriques, des capteurs CPV (11) eux-mêmes étant alimentés avec une tension donnée, et la lumière émise par eux par le biais des lentilles (15) étant captée et évaluée,
e) le module concentrateur est ensuite amené à un dispositif destiné à contrôler l'étanchéité (5) des modules concentrateurs finis, ceux-ci étant chargés à l'intérieur avec de l'air comprimé et l'émission d'air comprimé étant contrôlée,
f) les résultats de la mesure du flux lumineux généré et du contrôle de l'étanchéité sont utilisés pour évaluer la qualité du module concentrateur concerné et une classification correspondante est effectuée.

3. Procédé selon la revendication 2, **caractérisé en ce que** les lignes de liaison électriques, éléments de liaison (17) et plaques de contact collectrices (19) à apposer sur la plaque porte-capteur (13) sont prélevés automatiquement d'un stock et amenés dans la zone de moyens de maintien correspondants.

4. Procédé selon la revendication 2 ou 3, **caractérisé en ce que** les partenaires de mise en contact sont fixés dans leur position voulue par des moyens de maintien commandés automatiquement avant la connexion au moyen du dispositif de mise en contact à laser, le dispositif de mise en contact à laser garantissant que les deux conducteurs à relier ne sont pas touchés par l'outil de connexion, ne sont chauffés que pendant un temps très court et par conséquent ne se déforment quasiment pas.

5. Procédé selon 1"une des revendications 2 à 4, **caractérisé en ce que** le positionnement des moyens de maintien est orienté par commande laser sur des repères sur le module concentrateur.
